# EUROPEAN PATENT APPLICATION

(11) **EP 1 336 630 A2**
(43) Date of publication of application: **20.08.2003**
(21) Application number: 03250915.0
(22) Date of filing: 14.02.2003
(51) Int. Cl.: C08G 18/62, C08G 18/67, C08G 18/81, G03F 7/00

(54) **Functionalized polymer**

(30) Priority: 15.02.2002 US 357416 P
(71) Applicant: Shipley Co. L.L.C., Marlborough, MA 01752 (US)
(72) Inventor: Barr, Robert K., Shrewsbury, Massachusetts 01545 (US); Keil, Charles R., Mission Viejo, California 92692 (US); Lubovoski, Steven M., Anaheim, California 92804 (US)
(74) Representative: Kent, Venetia Katherine

(57) **Abstract**

A functionalized polymer containing a main chain derived from polyerizable monomers and pendent functional groups derived from isocyanates terminated with α or β ethylenically or acetyenically unsaturated groups. The functionalized polymer forms a good film and may be employed in industries where film forming polymers are used. Such industries include lithography, adhesives, electrophotoimaging, and the like. The functionalized polymers are self cross-linking and are suitable for use as polymer binders in both primary and secondary photoimaging compositions.

## Description

### Background of the Invention

The present invention is directed to a functionalized polymer containing isocyante derived, pendent functional groups. More specifically, the present invention is directed to a functional polymer containing isocyanate derived, pendent functional group with terminal unsaturated groups.

Functionalized polymers are employed for numerous purposes in a wide variety of industries. Functionalized polymers that readily form films on a surface are highly desirable for use in the fields of lithography, optical data storage, decorative pigments, adhesives, cosmetics, security applications or active and passive optical elements such as polarizers, optical retarders or color filters, electrophotographic imaging members, and the like.

For example, U.S. 5,037,913 to Leussler et al. discloses a hydroxylated acrylic copolymer in solid form that can be used as a binder for paints and varnishes. The hydroxylated acrylic copolymers are suspension polymerization products of hydroxylated acrylates or methacrylates, and acrylic or methacrylic, acid and contain from 0.5 to 8 % free hydroxyl groups and from 0.1 to 5% free carboxyl groups. The free hydroxyl and carboxyl groups of the copolymer may react with isocynates or their prepolymers, amines with -NH-CH₂OH- groups or epoxy groups. Hydroxyl groups of the copolymer may react with isocynate groups in a one to one mole ratio.

In lithography, polymers are employed in photoimageable compositions such as photoresists. The polymers function as a binder for the other components of the photoresist composition. Other components of photoresists include cross-linking monomers that cross-link after exposure to actinic radiation, and photoinitiators. Photoinitiators initiate the cross-linking reaction between the cross-linking monomers upon light exposure. Other additives included in photoresists include anti-striation reagents, plasticizers, speed enhancers, fillers, dyes, and the like. The polymer binder takes up space in the photoresist composition and is passively linked to the cross-linking monomers by folding around the monomers.

Photoresists may be primary photoimaging resists or secondary photoimaging resists. Primary photoresists are used to form temporary coatings on substrates. Secondary photoresists are hardenable and form permanent layers, e.g., solder masks. Photoresists are used to make printed circuits, printing plates, solder masks and the like. Photoresists have various requisites such as excellent etching resistance, heat resistance, adhesion and developable in developer solutions such as highly alkaline solutions. However, the lithographic industry has found that the synthesis of a polymer that can be employed in a photoresist and that satisfies all of the requisites is difficult. For example, a polymer having a polyacrylate main chain or backbone can be easily synthesized, but such a polymer has poor etching resistance and has difficulties in the developing process. In order to secure etching resistance, workers in the art have considered adding an alicyclic unit to the main chain. However, to form a copolymer by adding an alicyclic unit to a main chain composed of alicyclic units is difficult.

U.S. Pat. No. 5,296,334 discloses a styrene/maleic anhydride binder copolymer esterified with a (meth)acrylate functional alcohol such as hydroxyethylmethacrylate. By adding (meth)acrylate functionality to the binder polymer, the binder polymer, along with acrylate functional monomers enter into the photoinitiated cross-linking reaction, thereby increasing the cross-linked density of the exposed photoresist. Increased cross-linked density provides for a highly suitable secondary photoimageable composition.

(Meth)acrylate functional binder polymers such as those taught in U.S. Pat. No. 5,296,334 have proven valuable in secondary photoimageable compositions, such as those used for forming permanent layers, e.g., solder masks. On the other hand, (meth)acrylate functional binder polymers have proved difficult to incorporate into primary photoimaging resists. In particular, the increased cross-linking density afforded by the (meth)acrylate functionality significantly interferes with the stripping process of printed circuit board fabrication. In fact, the increased (meth)acrylate functionality combined with the high molecular weight and hydrophobic character of the styrene component made stripping almost impossible in an aqueous sodium hydroxide type stripping solution. Further, the ethylene oxide link in the hydroxyethylmethacrylate type monomers created potential problems with water sensitivity within the polymerized portion of the photoimageable composition during developing, etching and plating processing steps.

U.S. 6,045,973 discloses a copolymer binder having a styrene/maleic anhydride backbone and half-esterified with a (meth)acrylate functional hydroxyl terminated oligomer. The copolymer is prepared by initially copolymerizing styrene and maleic anhydride by conventional free-radical polymerization procedures to form what is referred to as the anhydride-functional backbone. Subsequently, the anhydride-functional backbone is half-esterified with a (meth)acrylate-functional hydroxy-terminated oligomer by a condensation reaction. The copolymer has improved stripping ability in contrast to the copolymer binder of U.S. 5,296,334. The copolymer also provides good chemical resistance to acid plating baths and to acid etching solutions.

A disadvantage of polymers containing anhydride units is that they are brittle. If the photoresist is brittle, the photoresist may chip causing circuit line defects on a circuit board. Such polymers are plagued by many other problems such as chemical instability, i.e., highly reactive. Also, many of the anhydride groups in such polymers remain unfunctionalized thus leaving anhydride to wreck havoc in the final photoresist formulation. The anhydride groups readily cross-link between hydroxyl containing species in photoresist formulations limiting photoresist shelf-life and choices of photoresist formulation ingredients. The reactions used to make the functionalization or grafting of an anhydride ring opening esterification are ran at temperatures of between about 60 to about 80° C, and take a long time to complete, i.e., about 8 hours. Even after prolonged reaction times such functionalization of an anhydride ring opening esterification may remain incomplete.

Another problem associated with the difficulty of stripping primary imaging photoresists arises from the demand on circuit board manufacturers to reduce the size of printed circuit boards while at the same time increasing their functional capabilities. Consequently, the circuit lines and spaces on the circuit boards have continued to shrink, as more circuitry needs to be fit onto smaller surfaces. At the same time, metal plating heights have also increased above the thickness of the photoresist. This causes the metal to hang over the photoresist resulting in a very narrow space containing the photoresist being encapsulated by metal overplating. The photoresist is then trapped by the plated overhang and stripping is made difficult. If the photoresist is not stripped clean, ragged metal circuit lines result after etching which are unusable. Such circuit lines can cause short-circuiting on the board.

Some manufacturers have tried thicker photoresists to accommodate the increasing plating heights. However, such an approach is more expensive and limits resolution of the circuit lines. Many manufacturers use organic-based (amine- or organic solvent-containing) alkaline stripping solutions that produce a smaller stripped particle to facilitate stripping. While the organic strippers, e.g., solutions containing trimethylamine or tetramethylammonium hydroxide, remove the photoresist, such strippers are expensive relative to alkaline aqueous strippers (sodium hydroxide and potassium hydroxide), and have more waste treatment and environmental concerns associated with them. Further, due to emphasis in the industry on reducing solvent emissions in the workplace, solvent-strippable photoresists are much less desirable than the aqueous-strippable. Accordingly, there is a need for improved primary imaging photoresists.

Secondary imaging photoresists also suffer from a number of problems. To best serve their intended purpose, secondary imaging photoresists such as solder masks desirably exhibit a high degree of chemical resistance to solder and the fluxes used in soldering operations. Solder masks also desirably have a high degree of thermal resistance relative to the elevated temperatures used in soldering operations. Many solder masks produced from photosensitive compositions are deficient in these regards, having tendencies to degrade, blister or separate from circuit boards under conditions of soldering applications. Yet other photosensitive resin compositions produce solder masks that are excessively brittle with increased tendency to chip and flake under conditions encountered in handling and processing of circuit boards on which they are arranged. Attempts at solving such problems often are counter-productive, i.e., generating problems associated with the photosensitive composition itself such as premature curing, instability, short shelf-life and the like.

Instability of a photoresist composition results in a short shelf life. Instability may result from the cross-linking monomers included in the photoresist composition. Prior to exposure of a photoresist composition to actinic radiation, each monomer is a potential reactant with another monomer. If not properly stored or when the photoresist is prematurely exposed to a radiation source, the monomers may prematurely react, thus spoiling the composition and reducing shelf life. Also, after exposure of the photoresist composition to actinic radiation, a fair proportion of the cross-linking monomers may not react. Thus, improper curing of the photoresist may occur resulting in brittle or poorly chemically resistant photoresist.

Formulation of a primary imaging photoresist or a secondary imaging photoresist involves a careful balancing of factors, often seemingly inconsistent, in order to attain desirable properties in the photoresist. Accordingly there is a need for a functionalized polymer that improves photoresist flexiblity, stripping ability with aqueous strippers, good chemical resistance as well as improved resolution and adhesion, and provides a stable photoresist composition.

### Summary of the Invention

The present invention is directed to a functionalized polymer composed of a main chain derived from ethylenically or acetylenically unsaturated monomers with pendent functional groups derived from isocyante compounds, and where the pendent functional groups terminate in one or more α or β ethylenically or acetylenically unsaturated groups.

Advantageously, the functionalized polymers of the present invention have film forming properties and may be employed in various industries where polymer films or coatings are desired. The properties of the functionalized polymers of the present invention make them highly suitable in compositions used in the lithographic industry such as photoresists. The functionalized polymers have good flexibility, are readily stripped with aqueous strippers, chemically resistant to acid plating baths and etching compositions. The functionalized polymers of the present invention when employed in UV and radiation curable coatings provide good resolution and scratch/mar-resistance. Another advantage of the functionalized polymer is that the polymer may act as the sole cross-linking component in a formulation. Thus, additional monomers or oligomers need not be included in the formulation. Exclusion of such monomers or oligomers improves the stability of compositions containing the functionalized polymer as well as their shelf life.

The present invention also is directed to a method of making the functionalized polymer. The method involves reacting a compound containing at least one free isocyanate group with a suitable functional group such as carboxyl, hydroxyl or aminyl on a polymer or copolymer main chain under mild reaction conditions.

A primary objective of the present invention is to provide an improved film forming, functionalized polymer.

Another objective of the present invention is to provide a functionalized polymer that can act as the sole cross-linking component in a composition.

An additional objective of the present invention is to provide for an improved binder polymer for photoresist compositions.

A further objective of the present invention is to provide for a photoresist composition having improved flexibility, stripping ability, and chemical resistance.

Other objectives and advantages of the invention may be ascertained by a person of skill in the art upon reading the description of the invention and the appended claims.

### Brief Description of the Drawings

Figure 1 is a graph of the % dry film photoresist adhesion to FR4/glass-epoxy coupons in a tape adhesion test; and
Figure 2 is a graph of the amount of copper underplating with a dry film photoresist composed of binder polymers of varying amounts of diisocyanate derived functional groups.

### Detailed Description of the Invention

The functionalized polymer has a main chain or backbone that is derived from ethylenically or acetylenically unsaturated polymerizable monomers, and at least one monomer employed to make the polymer backbone has a group that is free to react with the isocyanate group of an isocyanate compound to join the isocyanate compound to the polymer backbone to form a pendent functional group. At least one pendent functional group terminates in one or more α or β ethylencially or acetylenically unsaturated group. An isocyanate compound within the scope of the present invention means any compound that contains at least one free -N=C=O group. Isocyanates within the scope of the present invention include isocyanates, diisocyanates, triisocyanates and the like. Such isocyanates include aliphatic, alicyclic, aromatic as well as heterocyclic isocyanate compounds. Examples of such compounds are discussed below.

A "moiety" within the scope of the present invention means a distinct structural component of the functionlized polymer and is synonymous with the term "group". The term "polymer" means both polymer and copolymer. "Pendent" means a structural component of the functionalized polymer that is joined to or suspended from the main chain or backbone of the functionalized polymer by a chemical bond. "(Meth)acrylate" means both acrylate and methacrylate and (meth)acrylic means both acrylic and methacrylic. "Monomer" means any ethylenically or acetylenically unsaturated compound that may be polymerized.

Functional polymers within the scope of the present invention may be prepared by a post polymerization functionalization process. In post polymerization functionalization, the main chain or backbone and the isocyanate derived functional pendent components are prepared separately. After the preparation of each of the separate components that make up the polymer are prepared, they are then joined together in a separate reaction process to form the final functionalized polymer product.

The main chain or backbone of functionalized polymers of the present invention may be derived from monomers which include, but are not limited to, acid functional monomers, base functional monomers, water soluble functional monomers or mixtures thereof.

Examples of suitable ethylenically or acetylenically unsaturated monomers include, but are not limited to: (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, substituted ethylene monomers, cyclic olefins, substituted cyclic olefins, and the like. Preferred monomers include (meth)acrylic acid, alkyl (meth)acrylates and vinyl aromatic monomers.

Typically, the alkyl (meth)acrylates useful in the present invention are (C₁-C₂₄)alkyl (meth)acrylates. Suitable alkyl (meth)acrylates include, but are not limited to, "low cut" alkyl (meth)acrylates, "mid cut" alkyl (meth)acrylates and "high cut" alkyl (meth)acrylates.

"Low cut" alkyl (meth)acrylates are typically those where the alkyl group contains from 1 to 6 carbon atoms. Suitable low cut alkyl (meth)acrylates include, but are not limited to: methyl methacrylate, methyl acrylate, ethyl acrylate, propyl methacrylate, butyl methacrylate, butyl acrylate, isobutyl methacrylate, hexyl methacrylate, cyclohexyl methacrylate, cyclohexyl acrylate and mixtures thereof.

"Mid cut" alkyl (meth)acrylates are typically those where the alkyl group contains from 7 to 15 carbon atoms. Suitable mid cut alkyl (meth)acrylates include, but are not limited to: 2-ethylhexyl acrylate ("EHA"), 2-ethylhexyl methacrylate, octyl methacrylate, decyl methacrylate, isodecyl methacrylate (based on branched (C₁₀)alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate and mixtures thereof. Particularly useful mixtures include dodecyl-pentadecyl methacrylate, a mixture of linear and branched isomers of dodecyl, tridecyl, tetradecyl and pentadecyl methacrylates; and lauryl-myristyl methacrylate.

"High cut" alkyl (meth)acrylates are typically those where the alkyl group contains from 16 to 24 carbon atoms. Suitable high cut alkyl (meth)acrylates include, but are not limited to: hexadecyl methacrylate, heptadecyl methacrylate, octadecyl methacrylate, nonadecyl methacrylate, cosyl methacrylate, eicosyl methacrylate and mixtures thereof. Particularly useful mixtures of high cut alkyl (meth)acrylates include, but are not limited to: cetyl-eicosyl methacrylate, which is a mixture of hexadecyl, octadecyl, cosyl and eicosyl methacrylate; and cetyl-stearyl methacrylate, which is a mixture of hexadecyl and octadecyl methacrylate.

The mid-cut and high-cut alkyl (meth)acrylate monomers described above are generally prepared by standard esterification procedures using technical grades of long chain aliphatic alcohols, and these commercially available alcohols are mixtures of alcohols of varying chain lengths containing between 10 and 15 or 16 and 20 carbon atoms in the alkyl group. Examples of these alcohols are the various Ziegler catalyzed ALFOL alcohols from Vista Chemical company, i.e., ALFOL 1618 and ALFOL 1620, Ziegler catalyzed various NEODOL alcohols from Shell Chemical Company, i.e. NEODOL 25L, and naturally derived alcohols such as Proctor & Gamble's TA-1618 and CO-1270. Consequently, for the purposes of this invention, alkyl (meth)acrylate is intended to include not only the individual alkyl (meth)acrylate product named, but also to include mixtures of the alkyl (meth)acrylates with a predominant amount of the particular alkyl (meth)acrylate named.

The alkyl (meth)acrylate monomers useful in the present invention may be a single monomer or a mixture having different numbers of carbon atoms in the alkyl portion. Also, the (meth)acrylamide and alkyl (meth)acrylate monomers useful in the present invention may optionally be substituted. Suitable optionally substituted (meth)acrylamide and alkyl (meth)acrylate monomers include, but are not limited to: hydroxy (C₂-C₂₀)alkyl (meth)acrylates, dialkylamino (C₂-C₂₀)alkyl (meth)arylates, dialkaylamino (C₂-C₂₀)alkyl (meth)acrylamides, preferably, hydroxy(C₂-C₆)alkyl (meth)acrylates, dialkylamino(C₂-C₆)alkyl (meth)acrylates, dialkylamino(C₂-C₆)alkyl (meth)acrylamides.

Particularly useful substituted alkyl (meth)acrylate monomers are those with one or more hydroxyl groups in the alkyl radical, especially those where the hydroxyl group is found at the β-position (2-position) in the alkyl radical. Hydroxyalkyl (meth)acrylate monomers in which the substituted alkyl group is a (C₂-C₆)alkyl, branched or unbranched, are preferred. Suitable hydroxyalkyl (meth)acrylate monomers include, but are not limited to: 2-hydroxyethyl methacrylate ("HEMA"), 2-hydroxyethyl acrylate ("HEA"), 2-hydroxypropyl methacrylate, 1-methyl-2-hydroxyethyl methacrylate, 2-hydroxy-propyl acrylate, 1-methyl-2-hydroxyethyl acrylate, 2-hydroxybutyl methacrylate, 2-hydroxybutyl acrylate and mixtures thereof.

Other substituted monomers useful in the present invention are those with an amino group or alkylamino group. Examples include, but are not limited to: methylaminoethyl methacrylate, methylaminoethyl acrylate, N-methylaminoethyl methacrylamide, N-methyl-aminopropyl methacrylamide, N-methylaminobutyl methacrylamide, N-ethylaminoethyl methacrylamide, N-ethylaminopropyl methacrylamide, N-ethylaminobutyl methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-maleimide of dimethylaminopropylamine and mixtures thereof.

Other substituted (meth)acrylate monomers useful in the present invention are silicon-containing monomers such as γ-propyl tri(C₁-C₆)alkoxysilyl (meth)acrylate, γ-propyl tri(C₁-C₆)alkylsilyl (meth)acrylate, γ-propyl di(C₁-C₆)alkoxy(C₁-C₆)alkylsilyl (meth)acrylate, γ-propyl di(C₁-C₆)alkyl(C₁-C₆)alkoxysilyl (meth)acrylate, vinyl tri(C₁-C₆)alkoxysilyl (meth)acrylate, vinyl di(C₁-C₆)alkoxy(C₁-C₆)alkylsilyl (meth)acrylate, vinyl (C₁-C₆)alkoxydi(C₁-C₆)alkylsilyl (meth)acrylate, vinyl tri(C₁-C₆)alkylsilyl (meth)acrylate, 2-propylsilsesquioxane (meth)acrylate and mixtures thereof.

The vinyl aromatic monomers useful as unsaturated monomers in the present invention include, but are not limited to: styrene, hydroxystyrene, α-methylstyrene, vinyltoluene, *p*-methylstyrene, ethylvinylbenzene, vinylnaphthalene, vinylxylenes, and mixtures thereof. The vinylaromatic monomers also include their corresponding substituted counterparts, such as halogenated derivatives, i.e., containing one or more halogen groups, such as fluorine, chlorine or bromine; and nitro, cyano, (C₁-C₁₀)alkoxy, halo(C₁-C₁₀)alkyl, carb(C₁-C₁₀)alkoxy, carboxy, amino, (C₁-C₁₀)alkylamino derivatives and the like.

The nitrogen-containing compounds and their thio-analogs useful as unsaturated monomers in the present invention include, but are not limited to: vinylpyridines such as 2-vinylpyridine or 4-vinylpyridine; (C₁-C₈)alkyl substituted N-vinyl pyridines such as 2-methyl-5-vinyl-pyridine, 2-ethyl-5-vinylpyridine, 3-methyl-5-vinylpyridine, 2,3-dimethyl-5-vinyl-pyridine, and 2-methyl-3-ethyl-5-vinylpyridine; methyl-substituted quinolines and isoquinolines; N-vinylcaprolactam; N-vinylbutyrolactam; N-vinylpyrrolidone; vinyl imidazole; N-vinyl carbazole; N-vinyl-succinimide; (meth)acrylonitrile; *o*-, *m-,* or *p*-aminostyrene; hydroxystylene; maleimide; N-vinyl-oxazolidone; N,N-dimethyl aminoethyl-vinyl-ether; ethyl-2-cyano acrylate; vinyl acetonitrile; N-vinylphthalimide; N-vinyl-pyrrolidones such as N-vinyl-thio-pyrrolidone, 3 methyl-1-vinyl-pyrrolidone, 4-methyl-1-vinyl-pyrrolidone, 5-methyl-1-vinyl-pyrrolidone, 3-ethyl-1-vinyl-pyrrolidone, 3-butyl-1-vinyl-pyrrolidone, 3,3-dimethyl-1-vinyl-pyrrolidone, 4,5-dimethyl-1-vinyl-pyrrolidone, 5,5-dimethyl-1-vinyl-pyrrolidone, 3,3,5-trimethyl-1-vinyl-pyrrolidone, 4-ethyl-1-vinyl-pyrrolidone, 5-methyl-5-ethyl-1-vinyl-pyrrolidone and 3,4,5-trimethyl-1-vinyl-pyrrolidone; vinyl pyrroles; vinyl anilines; and vinyl piperidines.

The substituted ethylene monomers useful as unsaturated monomers in the present invention include, but are not limited to: vinyl acetate, vinyl formamide, vinyl chloride, vinyl fluoride, vinyl bromide, vinylidene chloride, vinylidene fluoride, vinylidene bromide, tetrafluoroethylene, trifluoroethylene, trifluoromethyl vinyl acetate, vinyl ethers and itaconic anhydride.

Suitable cyclic olefin monomers useful in the present invention are (C₅-C₁₀) cyclic olefins, such as cyclopentene, cyclopentadiene, dicylopentene, cyclohexene, cyclohexadiene, cycloheptene, cycloheptadiene, cyclooctene, cyclooctadiene, norbornene, maleic anhydride and the like. Such cyclic olefins also include spirocyclic olefin monomers such as spirocyclic norbornenyl monomers, spirocyclic cyclohexene monomers, spirocyclic cyclopentene monomers and mixtures thereof. Suitable substituted cyclic olefin monomers include, but are not limited to, cyclic olefins having one or more substituent groups selected from hydroxy, aryloxy, halo, (C₁-C₁₂)alkyl, (C₁-C₁₂)haloalkyl, (C₁-C₁₂)hydroxyalkyl, (C₁-C₁₂)halohydroxyalkyl such as (CH₂)ₙ,C(CF₃)₂OH where n' = 0 to 4, (C₁-C₁₂)alkoxy, thio, amino, (C₁-C₆)alkylamino, (C₁-C₆)dialkylamino, (C₁-C₁₂)alkylthio, carbo(C₁-C₂₀)alkoxy, carbo(C₁-C₂₀)haloalkoxy, (C₁-C₁₂)acyl, (C₁-C₆)alkylcarbonyl(C₁-C₆)alkyl, and the like. Particularly suitable substituted cyclic olefins include maleic anhydride and cyclic olefins containing one or more of hydroxy, aryloxy, (C₁-C₁₂)alkyl, (C₁-C₁₂)haloalkyl, (C₁-C₁₂)hydroxyalkyl, (C₁-C₁₂)halohydroxyalkyl, carbo(C₁-C₂₀)alkoxy, and carbo(C₁-C₂₀)haloalkoxy. It will be appreciated by those skilled in the art that the alkyl and alkoxy substituents may be optionally substituted, such as with halogen, hydroxyl, cyano, (C₁-C₆)alkoxyl, mercapto, (C₁-C₆)alkylthio, amino, acid labile leaving group and the like. Suitable carbo(C₁-C₂₀)alkoxy substituents include, but are not limited to, those of the formula C(O)O-LG, wherein LG is a leaving group including, but are not limited to, alkyl groups having 4 or more carbon atoms with at least one quaternary carbon atom bonded directly to a carboxylate oxygen such as tert-butyl esters, 2,3-dimethylbutyl esters, 2-methylpentyl esters, 2,3,4-trimethylpentyl esters, alicyclic esters, acetals or ketals from vinyl ethers or enols such as-O-(CH(CH₃)OC₂H₅) or -O-(CH₂OC₂H₅), tetrahydropyran. Suitable alicyclic esters as leaving groups include adamantyl, methyladamantyl, ethyladamantyl, methylnorbornyl, ethylnorbornyl, ethyltrimethylnorbornyl, ethyl fenchol and the like.

Functionalized polymers of the present invention also may contain functional monomers such as vinyl alcohol, vinyl pyrrolidone or mixtures thereof that provide for a water soluble polymer. Such water soluble functional polymers have a molecular weight of 2,000 daltons to about 100,000 daltons. Such functionalized polymers are typically water soluble at above about 30° C, and compose at least about 5 mole percent of the polymer backbone. More typically, water soluble functional monomers compose at least about 15 mole percent of the polymer backbone, preferably from about 30 mole percent to about 60 mole percent.

The molecular weight of the polymer backbone may range from at least about 1,000 daltons. More typically, the molecular weight of the polymer backbone may range from about 5,000 to about 500,000 daltons. The main chain or polymer backbone may be made by any suitable method in the art such as free-radical polymerization. For example, monomers chosen from the list above are dissolved in an appropriate solvent and heated in a reaction vessel in the presence of a thermal free radical initiator to initiate polymerization. Examples of suitable initiators include, but are not limited to, peroxide compounds, such as dibenzoyl peroxide, and azo compounds, such as 2,2'-azobis(2-methylpropanenitrile), 2,2'-azobis(2-methylbutanenitrile), 2,2'-azobis(2,4-dimethylethylpentanenitrile), and 1,1'-azobis(cyclohexanecarbonitrile).

After the polymer backbone is prepared, the polymer backbone is mixed with an isocyanate compound at reaction temperatures below 80° C. Preferably, reaction temperatures are run at mild temperatures of from about 20° C to about 60° C. Mixing and heating are continued until the reaction is complete. Typically, the reaction continues for about 1 hour to less than 8 hours, preferably from about 4 to about 6 hours. Advantageously, the method of the present invention is performed over short time periods, thus less energy is utilized in preparing the functionalized polymer. Reactions that take place occur between a free isocyanate group on the isocyanate compound and a hydroxyl group, carboxyl group, or primary or secondary aminyl functional group attached to the polymer main chain or backbone. One mole of free isocyanate reacts with one mole of a hydroxyl, carboxyl, or primary or secondary aminyl on the polymer main chain. The reaction may be self quenching. There is believed to be no source of free radicals, or a source of cations or anions at the end of the reaction between the isocyanate group(s) and hydroxyl, carboxyl, or aminyl group(s) on the polymer backbone. As a precaution water, alcohol, or other chemical speicies with a labile hydrogen, and a suitable catalyst, such as triethylamine, may be added at the end of the reaction to quench any free isocyanate. Also, a suitable polymerization inhibitor may optionally be added to prevent premature cross-linking of terminal ethylenically or acetylenically unsaturated moieties such as a (meth)acrylate moiety. Reaction completion may be determined by using standard analytical instruments well known in the art.

The methods according to the present invention may be carried out in the presence of an inert dry solvent, for example, an ether such as diisopropyl ether, ethylene glycol dimethyl ether, diethylene glycol dimethyl ether, 1,4-dioxane, tetrahydrofuran or 1,2-dimethoxy propane; an ester such as butyrolactone, ethylene glycol carbonate or propylene glycol carbonate; an ether ester such as methoxyethyl acetate, ethoxyethyl acetate, 1-methoxypropyl-2-acetate, 2-methoxypropyl-1-acetate, 1-ethoxypropyl-2-acetate or 2-ethoxypropyl-1-acetate; ketones such as acetone or methyethyl ketone; nitriles such as acetonitirle, propionitrile or methoxypropionitrile; sulfones such as sulfolan, dimethylsulfone or diethylsulfone; and phosphoric acid esters such as trimethyl phosphate or triethyl phosphate. The processes may also be carried out without such solvents.

To accelerate the reactions of the methods of the present invention, any suitable catalyst employed in polymerization reactions can be used. Tin containing catalysts are preferred, such as dibutylin dilaurate, tin(II) octoate or dibutylin dimethoxide. Such catalysts are employed in an amount of from about 0.001% to about 2.5% by weight, preferably from about 0.005% to about 1.5% by weight based on the amount of reactants.

Stabilizers or polymerization inhibitors may optionally be added to the reaction steps to stabilize free-radical polymerization. Polymerization inhibitors are added to reaction mixtures in amounts of from about 0.001% to about 2% by weight, in particular from about 0.005% to about1.0% by weight of the reactants. Examples of such inhibitors include, but are not limited to, hydroquinones, or hydroquinone monoalkyl ethers, 2,6-di-tert-butylphenols, such as 2,6-di-tert-butylcresol, nitrosamines, phenothiazines or phosphorous esters.

Free isocyanate, i.e., -N=C=O, reacts with a hydroxyl group from the polymer backbone, or a hydroxyl group from a carboxyl group from the polymer backbone to form a R-NH-C(O)-P linkage where P is the polymer backbone, and R is a pendent group from the isocyanate group. Specific examples include a urethane group containing compound or a biuret group containing compound. A free isocyanate that reacts with a primary or secondary amine moiety joined to the polymer backbone forms a R-NH-C(O)-NR¹-G-P urea (carbamide) linkage where R¹ includes, but is not limited to, hydrogen a linear, branched or unsubstituted or substituted alkyl, or an unsubstituted or substituted aryl. Substituent groups include, but are not limited to, halogen, such as fluorine, bromine, chloride or iodine, hydroxyl, carboxyl, or primary or secondary amine. A substituent group replaces a hydrogen on a carbon atom. G is an organic moiety that joins the nitrogen to the polymer chain. G includes, but is not limited to, an alkyl, or a substituted aryl where the nitrogen is joined to the aryl by an alkyl chain. The alkyl of G may be linear or branched (C₁-C₂₄) alkyl. A free isocyanate that reacts with a polyalkoxylated moiety from the polymer backbone forms a R-NH-C(O)-O(AO)ₓ-C(O)-P linkage where A is a linear or branched (C₁-C₂₄)alkyl, and x is an integer from 0 to 1,000, preferably from 1 to 200. R may terminate in one or more functional groups such as ethylenically or acetylenically unsaturated moieties that permit functionalized polymers of the present invention to self cross-link as in photoresist compositions described below.

In one embodiment of the present invention, isocyanate compounds used to prepare the functionalized polymers of the present invention include urethane/ethylenically or acetylenically unsaturated isocyanates. Such compounds have a -NHC(O)- moiety, at least one free isocyanate group (-N=C=O), and an ethylenically or acetylenically unsaturated moiety such as a (meth) acrylate that is at a terminsus of the isocyanate compound. Biuret ethylenically or acetylenically unsaturated isocyanates have a -NH-C(O)-N-C(O)-NH- moiety, at least one free isocyanate group and an ethylenically or acetylenically unsaturated moiety at a terminus of the compound. R as described above is the isocyanate compound less the free isocyanate group that reacts with a functional group of the polymer backbone,i.e., hydroxyl, carboxyl or aminyl group. Examples of such compounds include, but are not limited to, the following general formulas:

O=C=N-Z-NH-C(O)-O-Y-O-C(O)-CR²=CH₂;

O=C=N-Z-N[-C(O)-NH-Z-N-C(O)-O-Y-O-C(O)-CR²=CH₂]₂; or

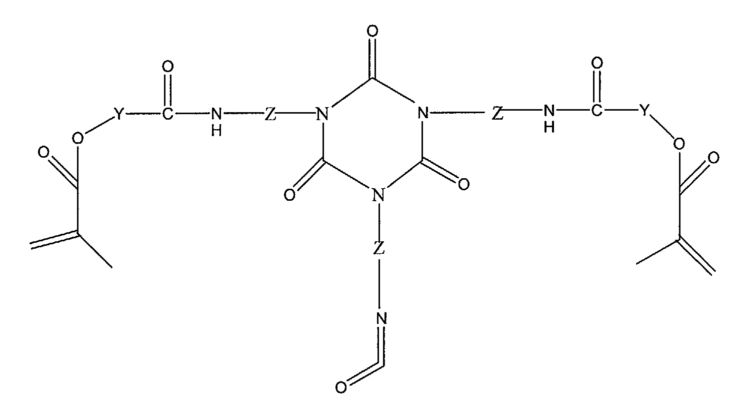

where Z includes, but is not limited to, alkyl, alkylene, cycloalkyl, aryl, heterocyclic alkyl, heteroaryl, a polymer such as a copolymer including a branched polymer or branched copolymer; Y includes, but is not limited to, alky, alkylene, cycloalkyl, aryl, heterocyclic alkyl, heteroaryl,-((CH₂)ᵤ-O-)ᵥ-(CH₂)_{w}-, or -((CH₂)ᵤ-C(O)-O-)ᵥ-(CH₂)_{w}-, where u, and w are integers of from 1 to 10, and v is an integer of from 0 to greater than 1,000, preferably from 1 to 200, most preferably from 5 to 10. R² is hydrogen or or (C₁-C₄) alkyl. Preferably R² is hydrogen or methyl. Heteroatoms include, but are not limited to, oxygen, sulfur, and nitrogen. The alkyl, alkylene, cycloalkyl, aryl, heterocyclic alkyl, heteroaryl and polymers may be unsubstituted or substituted. Examples of suitable substitutent groups include, but are not limited to, carboxyl, hydroxyl, (C₁-C₄) alkyl), aminyl such as a primary or secondary aminyl, or hydroxyaminyl, or -CN.

Examples of suitable alkyl groups include, but are not limited to, linear or branched (C₁-C₂₀) alkyl. Examples of alkenyl, cycloakyl or aryl groups include, but are not limited to, linear or branched (C₂-C₂₀) alkenyl, (C₅-C₆) cycloalky such as an isophorone, and (C₅-C₆) aryl such as phenyl.

The isocyanate compounds with at least one free isocyanate group may be prepared by any suitable method known in the art. Diisocyanates or triisocyanates that may be employed are either known or may be prepared by analogy to known compounds. Examples of suitable diisocyanates and triisocyanates include, but are not limited to, ethylene diisocyanate, propylene diisocyanate, butylene-1,3-diisocyanate, 1,6-hexamethylene diisocyanate, 2,2,4-trimethyl-hexamethylene diisocyanate, 2,4-dimethyl-6-ethyloctamethylene diisocyanate, cyclohexylene diisocyanate, cyclopentylene diisocyanate, 1,4-diisocyanatomethyl-cyclohexane, 1,3-diisocyanatoethyl-cyclohexane, toluylene diisocyanate, 3,3,5-trimethyl-1-isocyanato-5-isocyanatomethyl-cyclohexane, 2-butene-1,4-diisocyanate, isophorone diisocyanate, 1,6-hexamethylene diisocyanate biuret, 1,6-hexamethylene diisocyanate trimer, isophorone diisocyanate trimer, bis phenol A dimethacrylate capped with 2-hydroxethylmethacrylate capped with 1,6-hexamethylene diisocyanate trimer, and the like. Many of the foregoing listed diisocyantes and triisocyantes as well as the biurets and trimers may be purchased from Lyondell (located at 122 Melanney St., Houston, TX) or Bayer (located at 100 Bayer Rd., Pittsburg, PA 15025).

Isocyanates such as the diisocyanates and triisocyanates described above may then be reacted with a sufficient amount of one or more hydroxyl containing compounds such that one free isocyanate group is left to react with the main chain prepared as described above. As mentioned above, the reaction mole ratio of hydroxyl group to isocyanate group is about 1:1. Any suitable compound with at least one free hydroxyl group to react with an isocyanate group may be employed. An isocyanate compound of the present invention also may be reacted with another isocyanate compound having at least one free hydroxyl group. Hydroxyalkyl, hydroxyalkenyl, hydroxyaryl compounds and the like are examples of such compounds that may be employed. Hydroxyalkyl (meth)acrylates are one example of suitable compounds. Hydroxyethyl (meth)acrylate or hydroxypropyl (meth)acrylate (n or iso compounds) are examples of hydroxyl group-containing esters that are suitable. Other suitable hydroxyalkyl (meth)acrylates include, but are not limited to, 2-hydroxy-butyl (meth)acrylate, 4-hydroxy-butyl (meth)acrylate, 2-hydroxy-cyclohexyl (meth)acrylate, 2-hydroxyethylmethacrylate, and the like. Suitable polyethylene glycol mono (meth)acrylates also may be employed such as, but not limited to, diethylene glycol mono (meth)acrylate, triethylene glycol mono (meth)acrylate and the like. Hydroxyalicyclic (meth)acrylates, and hydroxyaromatic (meth)acrylates such as bis phenol A dimethacrylate also may be employed. U.S. Pat. No. 4,019,972 discloses a method of preparing urethanes that may be employed to practice the present invention, the entire disclosure of which is hereby incorporated herein by reference.

The functionalized polymers have an average molecular weight range of from about 1,500 daltons to about 1,000,000 daltons. More typically, the molecular weight range of the functionalized polymers is from about 10,000 daltons to about 800,000 daltons. The functionalized polymers of the present invention may be functionalized with one or more pendent functional moieties derived from isocyanate compounds in ranges of from about 1.0 to as high as about 100 mole percent of reactive sites on the polymer backbone, preferably from about 2.0 to about 20 mole percent, most preferably from about 5.0 to about 15 mole percent. Complete functionalization of the polymer backbone with isocyanates is not always desirable because such groups as hydroxyl and carboxyl groups provide for solubility in alkaline solutions Such solubility is highly desirable when the functionalized polymer is employed in photoresist. Acid functionality of the main chain may be a carboxylic acid functionality or may include, for example, a sulfonic acid or phosphoric acid functionality. Acid values of the functionalized polymers range from at least about 25 mg of potassium hydroxide/gram of polymer, preferably from at least about 90 mg, more preferably from at least about 120 mg, and most preferably up to about 300 mg. Typical acid number ranges are from about 50 mg to about 250 mg.

Advantageously, the functionalized polymers of the present invention are film forming polymers that form films that are flexible, and free of cosmetic effects such as fisheyes, orange peel and the like. Thus, the functionalized polymers may be employed in any industry where polymer film coatings are desired. Such industries include, but are not limited to lithography, electrophotographic imaging members, optical data storage, decorative pigments, adhesives, cosmetics, security applications or active and passive optical elements such as polarizers, optical retarders or color filters, paints and other surface coating compositions. The functionalized polymers also have good flexibility, and are readily soluble in aqueous alkaline solutions such as sodium hydroxide, potassium hydroxide, sodium carbonate, and the like. Because the functionalized polymers have good flexibility and solubility, the functionalized polymers are especially useful in photoresist compositions, particularly in primary imaging photoresists. The high solubility of the functionalized polymers in aqueous alkaline solutions enables photoresists made with the functionalized polymers to be easily stripped. The improved stripping ability eliminates or significantly reduces the problem of metal overhang during metal plating procedures in the manufacture of printed wiring boards as well as underplating, thus preventing short circuiting on the board. Additionally, undesirable and costly strippers such as organic-based, amine or organic solvent-containing strippers may be avoided. Thus, excessive waste treatment procedures may be eliminated from the printed wiring board procedures as well as environmental and worker safety concerns associated with such organic-based strippers. Good flexibility also provides for a photoresist that is not brittle and does not readily chip. Chipping, due to brittleness, can lead to circuit defects in printed wiring boards.

The functionalized polymers also have good adhesion to metal surfaces due to their pendent functional groups. The functionalized polymers are also self cross-linking. Thus, the functionalized polymers may be employed as the sole cross-linking agent in a photoresist composition. Advantageously, cross-linking monomers or oligomers employed in conventional photoresists may be eliminated. Thus, premature polymeriztion between the various components of a photoresist composition are avoided. Accordingly, both the stability and the shelf life of such photoresists are improved. Also, functionalized polymers of the present invention are economically advantageous because of the improved method of making isocyanate derived functionalized polymers is rapid, and reaction conditions are mild requiring less energy expenditure. Thus manufacturing costs are reduced and productivity is increased.

The functionalized polymers of the present invention may be employed in both primary imaging photoresists or in secondary imaging photoresists such as in solder masks. The functionalized polymers may act as both the binder polymer for the photoresist as well as the sole cross-linking agent in the photoresist composition. However, cross-linking monomers or oligomers may optionally be added to the photoresist composition. Functionalized polymers of the present invention compose from about 5% by weight to about 95% by weight of the photoresist composition. Preferably the functionalized polymers comprise from about 25% by weight to about 70% by weight, most preferably from about 40% by weight to about 60% by weight of the photoresist composition. The balance of the photoresist composition may include additional binder polymers, cross-linking monomers or oligomers, and conventional additives as described below. Such components may be added in conventional amounts.

Optional cross-linking agents that may be employed include a monomer, or a short chain oligomer having ethylenic unsaturation, particularly, α,β-ethylenic unsaturation functionality of 2 or greater. A mixture of monofunctional and multi-functional monomers may be used. Examples of monomers suitable for photoinitiated polymerizatioin include, but are not limited to, (meth)acrylic acid, maleic acid, fumaric acid, citraconic acid, 2-acrylamido-2-methylpropanesulfonic acid, 2-hydroxyethyl acrylol phosphate, 2-hydroxypropyl acrylol phosphate, 2-ethyl hexyl acrylate, n-butyl acrylate, n-hexyl acrylate, methyl (meth)acrylate, hydroxy ethyl acrylate, butyl (meth)acrylate, octyl acrylate, 2-ethoxy ethyl (meth)acrylate, t-butyl acrylate, 1,5-pentanediol di(meth)acrylate, N,N-diethylaminoethyl acrylate, ethylene glycol diacrylate, 1,3-propanediol di(meth)acrylate, decamethylene glycol di(meth)acrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, butylene glycol dimethacryalte, 1,2,4-butanetriol trimethacrytlate, 2,2,4-triemthyl-1,3-pentanediol dimethacrylate, pentaerythritol trimethacrylate, 1-phenyl ethylene-1,2-dimethacrylate, pentaerythritol tetramethylacrylate, trimethylol propane trimethacrylate, 1,4-benzenediol dimethacrylate; styrene and alkyl- and aromatic-substituted styrene, such as 2-methyl styrene and vinyl toluene and vinyl esters, such as vinyl (meth)acrylate. Also useful are (meth)acrylate terminated urethane oligomers prepared from hydroxy functional mono(meth)acrylates such as those described in U.S. Pat. No.5,744,282, the disclosure of which is hereby incorporated herein in its entirety by reference. The optional monomers or oligomers are included in the photoresists of the present invention in conventional amounts.

To initiate cross-linking of the functionalized polymers of the present invention or the optional monomers or oligomers upon exposure to actinic radiation, the photoimageable compositions of the present invention contain a photoinitiator chemical system. The photoinitiator chemical system may contain from between about 0.1% to about 20% by weight of the photoresist composition. Suitable photoinitiators include, but are not limited to 9-phenylacridine, n-phenylglycine, aromatic ketones (E.g., benzophenone, N,N"tetramethyl-4, 4'-diaminobenzophenone, N,N'-tetraethyl-4,4'-diaminobenzophenon, 4-methoxy-4'-dimethylaminobenzophenone, 3,3'-dimethyl-4-methoxybenzophenone, p,p'-bis(dimethylamino) benzophenone, p,p'-bis(diethylamino)-benzophenone,anthraquinone, 2-ethylanthraquinone, naphthaquinone, phenanthraquinone, benzoins (e.g., benzoin, benzoinmethylether, benzoinethylether, benzoinisopropylether, benzoin-n-butylether, benzoinphenylether, methylbenzoin, ethylbenzoin, and the like), benzyl derivatives (e.g., dibenzyl, benzyldiphenyldisulfide, benzyldimetehylketal (SIC), and the like), acridine derivatives (9-phenylacridine, 1,7-bis(9-acridinyl)heptane, and the like), thioxanthones (2-chlorothioxanthone, 2-methylthioxanthone, 2,4-diethylthioxanthone, 2,4-dimethylthixanthone, 2-isopropylthixanthone, and the like), acetophenones (e.g., 1,1-dichloroacetophenone, p-t-butyldichloro-acetophenone, 2,2-diethoxyacetphenone, 2,2-dimethoxy-2-phenylacetophenone, 2,2-dichloro-4-phenoxyacetopehnone, and the like), 2,4,5-triarylimidazole dimers (e.g., 2-(o-chlorophenyl)-4,5-diphenylimidazole dimer, 2-(o-chlorophenyl)-4,5-di(m-methoxyphenyl imidazole dimer, 2-(o-flurophenyl)-4,5-diphenylimidazole dimer, 2-(o-methoxyphenyl)4,5-diphenylimidazole dimer, 2-(p-methoxyphenyl)-4,5-diphenylimidazole dimer, 2,4-di(p-methoxyphenyl)-5-phenylimidazole dimer, 2-(2,4-dimethoxyphenyl)-4,5-diphenylimidazole dimer, 2-(p-methylmercaptophenyl)-4,5-diphenylimidazole dimer, and the like). Though not a free-radical generator, triphenylphosphine may be included in the photoinitiator chemical system as a catalyst.

The photoimageable compositions may also include one or more plasticizers in amounts of from about 0.5% to about 10.0% by weight of the composition. Examples of suitable plasticizers include, but are not limited to, phthalate ester (e.g., dibutylphthalate, diheptylphthalate, dioctylphthalate, and diallylphthalate), glycols (e.g., polyethylene glycol, and polypropylene glycol), glycol esters (e.g., triethylene-glycodiacetate, tetraethylene-glycoldiacetate, dipropylene-glycol-dibenzoate), phosphate esters (tricresylphosphate, triphenylphosphate), amides (p-toluenesulfoneamide, benzensulfoneamide, N-n-butylacetoneamide), aliphatic dibasic acid esters (diisobutyl-adipate, dioctyladipate, dimethylsebacate, dioctylazelate, dibutylmalate, triethylcitrate, tributylcitrate, triethylacetylcitrate, tri-n-propylacetylcitrate, tri-n-butylacetylcitrate, butyl-laurate, dioctyl-4,5-diepoxycyclohexane-1,2-dicarboxylate, glycerinetriacetylesters, dipropyleneglycol dibenzoate, polyethyleneglycol 200 dibenzoate, sucrose benzoate, trioctyl trimellitate, and the like.

Photoresist compositions of the present invention may also include a color former. Color formers are employed in amounts of from about 0.1% to about 1.0% by weight of the composition. Examples of suitable color formers include, but are not limited to, diphenylamine, dibenzylaniline, triphenylamine, diethylaniline, diphenyl-p-phenylenediamine, p-toluidine, 4,4'-biphenyldiamine, o-chloroaniline, leuco crystal violet, leuco malachite green, and the like.

Additionally, the photoimageable compositions may contain a wide variety of additional components as are well known in the art, including additional polymers, such as those that might be used to effect a final hardened cure of a solder mask, dyes, stabilizers, flexibilizing agents, fillers, and the like. A wide variety of additional polymeric or resin binders may be added to the photoresists. Such additional polymeric binders may include, as polymerized components, one or more acid functional monomers such as (meth)acrylic acid. For example, U.S. Pat. No. 5,952,153, the entire disclosure of which is hereby incorporated in its entirety herein by reference, discloses polymeric binders that have sufficient acid functionality to be employed in the photoresists of the present invention. When employed, such polymers may be used in amounts of from about 5% to about 35% by weight of the photoresist composition, preferably from about 10% to about 20% by weight.

Processing of the photoresist compositions is by any suitable means employed in the art. For example, a photoimageable composition layer, either formed from a liquid composition or transferred as a layer from a dry film, is applied to a substrate, such as a copper surface, of a metal-clad board. When a liquid photoresist composition is used, it may be applied to a substrate by any known means, such as spinning, dipping, roller coating and the like. Preferably, the photoresist compositions are formulated as a dry film. When a dry film is used, the dry film is composed of a liquid photoimageable composition dried onto a flexible sheet, e.g., polyethylene terephthalate. Optionally, a protective sheet, e.g., polyethylene, is provided on the surface of the dried photoimageable layer opposite the support sheet before the film is rolled into reels. The protective sheet is removed prior to application, e.g., lamination, to the metal-clad board. Once applied, the photoimageable composition layer is then exposed to actinic radiation through appropriate artwork. Exposure to actinic radiation polymerizes the cross-linking components in the light-exposed areas resulting in a cross-linked structure that is resistant to developer. Next, the composition is developed in dilute alkaline aqueous solution, such as a 1% sodium carbonate solution. The alkali solution causes salt formation with carboxylic acid groups of the functionalized polymer rendering the unexposed portions of the photoresist soluble and removable. After development, an etchant may be used to remove metal from areas where the photoresist was removed thereby forming a printed circuit. The remaining photoresist is then removed using an appropriate stripper, such as 1% to 3% sodium or potassium hydroxide aqueous solution. Organic based developers, such as tetraalkylammonium hydroxide based developers, may be used but are less preferred for the reasons discussed above.

Advantageously, the photoresist of the present invention has improved chemical resistance to acid etching solutions, improved resolution, adhesion to metal, and improved scratch/mar resistance. Also, the problems of overplating and underplating are eliminated or significantly reduced. While the functionalized polymer has been described in the context of photoresist compositions, the functionalized polymer may be employed where film forming polymers are used.

The following examples are intended to further illustrate the present invention but are not intended to limit the scope of the invention.

### Example 1

### Polymer of Methacrylic Acid and Methyl Methacrylate functionalized with: 1,6-Hexamethylene Diisocyanate Biuret - Polypropoxylated Hydroxypropylmethacrylate Moieties

A homogeneous solution containing about 62.0 grams of methacrylic acid and about 265.0 grams of methyl methacrylate was prepared. About 75% by weight of the homogeneous solution were transferred into a second flask. The homogeneous solution of the first flask was diluted to about 26.0% by weight solids and the homogeneous solution of the second flask was diluted to about 86.50% by weight solids by adding sufficient methyl ethyl ketone.

The first flask was mixed and heated to reflux under atmospheric conditions. About 2.0 grams of 2,2'-azobis (2-methylbutyronitrile) was added to the reaction mixture, mixed and held at reflux for about 30 minutes.

About 6.25 grams of 2,2'-azobis (2-methylbutyronitrile) was mixed with about 38.0 grams of methyl ethyl ketone and fed into the first flask along with the contents of the second flask over about 4 hours while maintaining reflux. An additional amount of about 9.0 grams of methyl ethyl ketone was then added to the first flask and the mixture was refluxed for an additional hour.

About 4.55 grams of 2,2'-azobis (2-methylbutyronitrile) were dissolved in about 48.0 grams of methyl ethyl ketone and mixed. The mixture was then added to the first flask over a period of about 90 minutes while maintaining reflux.

About 8.5 grams of 2,2'-azobis (2-methylbutyronitrile) were mixed with about 48.0 grams of methyl ethyl ketone and then fed into the reaction mixture over about 150 minutes while maintaining reflux. An additional amount of about 23.0 grams of methyl ethyl ketone were added to the reaction mixture. At the end of the reaction, 2,2'-azobis (2-methylbutyronitrile) was thermally killed off to below parts per million concentrations. The acrylic polymer main chain or back bone product was set aside.

About 150.0 grams of 1,6-hexamethylene diisocyante biuret (about 23.0% NCO) were added to a clean dry, nitrogen sparged flask. About 0.06 grams of dibutylin dilaurate, about 0.05 grams of Irganox® 1076 (antioxidant) and about 160.0 grams of methyl ethyl ketone were also added to the flask. The flask was sparged with dry air and stoppered. The components were mixed and heated at about 35° C.

In a separate clean dry air sparged addition funnel, about 193.0 grams of polypropoxylated hydroxypropylmethacrylate (hydroxyl number = about 158) was weighed out. The polypropoxylated hydroxypropylmethacrylate was added to the flask containing the 1,6-hexamethylene diisocyanate biuret over about 1 hour with mixing and maintaining a temperature of about 35° C. The addition funnel was then rinsed with about 118.0 grams of methyl ethyl ketone to remove any remaining polypropoxylated hydroxypropylmethacrylate. The rinse was added to the flask containing the biuret with a temperature increased to about 60° C. The reaction was maintained for about 3 hours at about 60° C. The reaction was monitored to determine completion of the synthesis of a urethane acrylate moiety by known analytical methods in the art.

The functionalized polymer was prepared by weighing out about 763.0 grams of the acrylic polymer (about 47% solids) and about 55.0 grams of methyl ethyl ketone to a clean, dry air sparged flask. The combination was mixed and heated to about 45° C. The urethane/acrylate moiety was then added to the acrylic polymer over about 1 hour. About 0.50 grams of Irganox® 1076 and about 28.0 grams of methyl ethyl ketone was added to the reaction mixture. The reaction contents were held at about 45°C for about 3 hours with constant mixing. The polymer main chain was about 6 mole percent functionalized with the moiety. P represents the polymer backbone with one functional moiety attached.

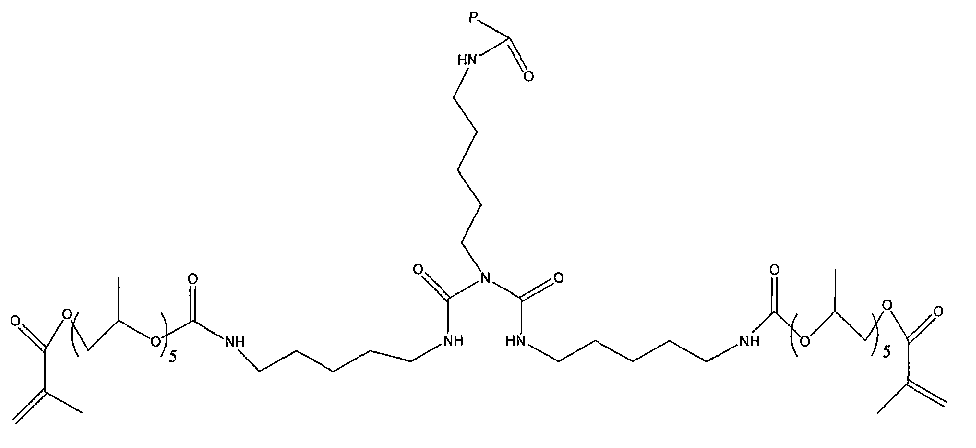

### Example 2

### Polymer of 2-Hydroxyethyl Methacrylate, Methacrylic Acid and Methyl Methacrylate Functionalized with: Isophorone Diisocyanate - Polypropoxylated Hydroxypropylmethacrylate Moieties

The step of preparing the acrylic polymer backbone was the same as in the method described in Example 1 above except that about 70.0 grams of 2-hydroxyethyl methacrylate was added to the mixture of methacrylic acid and methyl methacrylate.

The reaction conditions for preparing the functionalized pendent groups were the same as described in Example 1 above except that about 1 mole of isophorone diisocyanate was reacted with about one mole of hydroxy methacrylate to form a isophorone diisocyante hydroxy methacrylate moiety.

The isocyanate groups of the isophorone diisocyanate hydroxy methacrylate moiety were reacted with the hydroxyl groups of the 2-hydroxyethyl methacrylate moiety under the conditions described in Example 1 to form a functionalized polymer with functionalized pendent groups as shown below. The polymer was about 6 mole percent functionalized. P represents the polymer backbone.

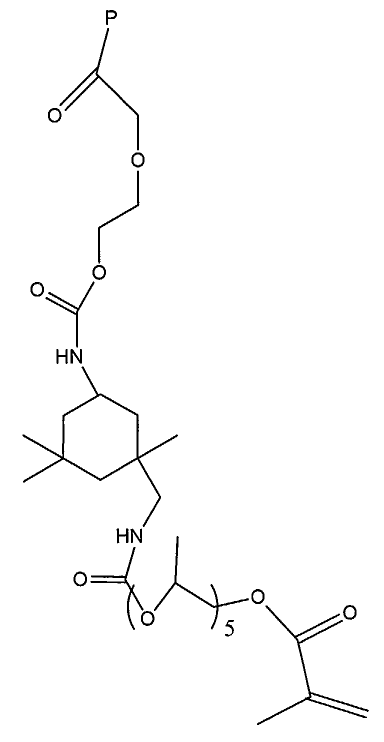

### Example 3

### Synthesis of 1,6-Hexamethylene Diisocyanate Trimer-Polyalkoxylated Hydroxyalkyl (meth)acrylate, or a 1,6-Hexamethylene Diisocyanate Trimer-Hydroxyalkyl (meth)acrylate (urethane/acrylate with at least one free isocyanate)

About one mole of 1,6-hexamethylene diisocyanate trimer is added to a clean dry, nitrogen sparged flask. About 0.06 grams of dibutylin dilaurate, about 0.05 grams of Irganox® (antioxidant) and about 160.0 grams of methyl ethyl ketone are also added to the flask. The flask is sparged with dry air and stoppered. The components are mixed and heated at about 35° C. About two moles of a polyalkoxylated hydroxyalkyl (meth)acrylate, or about two moles of hydroxyalkyl (meth)acrylate are added to the flask, mixed with the trimer, and heated at about 35° C for about one hour. The reaction temperature is increased to about 60° C and the reaction is maintained for about 3 hours. The resulting compound has the following general structure where n is an integer of from 0 to 1000, preferably from 1 to 200,1 is an integer of from 1 to 10, m is an integer of from 1 to 10 and R³ is (meth)acrylate.

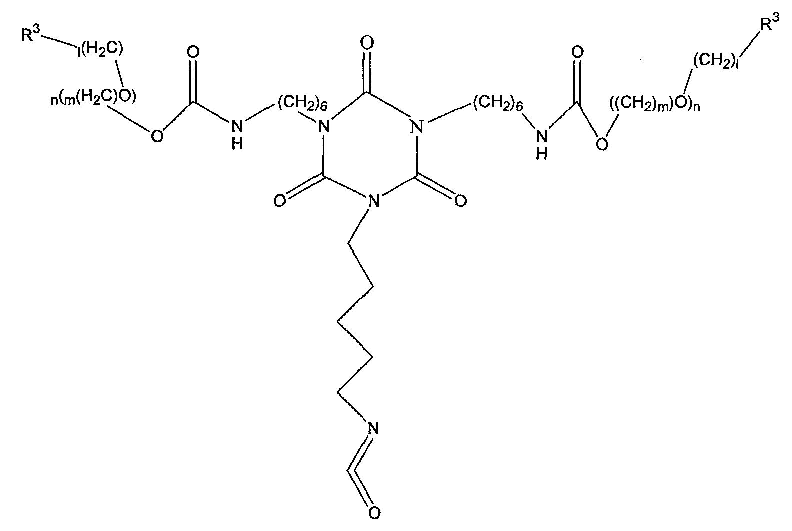

The foregoing urethane/acrylate with one free isocyanate group may be reacted with a polymer main chain containing free carboxyl, hydroxyl, or aminyl groups to form a functionalized polymer of the present invention.

### Example 4

### Synthesis of a 1,6-Hexamethylene Diisocyante-Polyalkoxylated Hydroxyalkyl (meth)acrylate, or a 1,6-Hexamethylene Diisocyante-Hydroxyalkyl (meth)acrylate

About one mole of 1,6-hexamethylene diisocyante is reacted with about one mole of a polyalkoxylated hydroxyalkyl (meth)acrylate or about one mole of hydroxyalkyl (meth)acrylate as described in the method of Example 3 above. The compounds have the following general formula:

(meth)acrylate-(CH₂)₁-(O(CH₂)ₘ)ₙ-O-C(O)-NH-(CH₂)₆-NCO

where n is an integer of from 0 to greater than 1000, preferably from 1 to 200,1 is an integer of from 1 to 10 and m is an integer of from 1 to 10.

The foregoing compounds may be reacted with a carboxyl, hydroxyl, or aminyl group on a polymer chain to form a functionalized polymer of the present invention.

### Example 5

### Synthesis of a Toluene 2,4-diisocyanate-Polyalkoxylated Hydroxyalkyl (meth)acryalte, or a Toluene 2,4-diisocyante-Hydroxyalkyl (meth)acrylate

About one mole of toluene 2,4-diisocyante is reacted with about one mole of a polyalkoxylated hydroxyalkyl (meth)acrylate or about one mole of a hydroxyalkyl (meth)acrylate as described in the procedure of Example 3 above. The compounds have the following general formula:

(meth)acrylate-(CH₂)₁-(O-(CH₂)ₘ)ₙ-OC(O)-NH-methylphenyl-NCO

where n is an integer of from 0 to greater than 1000, preferably from 1 to 200, 1 is an integer of from 1 to 10 and m is an integer of from 1 to 10.

The urethane/(meth)acrylate compounds with at least one isocyanate group may be reacted with a polymer chain having one or more of a carboxyl, hydroxyl, or aminyl group to form a functionalized polymer of the present invention.

### Example 6

Synthesis of a Polymeric Methylene Diphenyl Diisocyante-Polyalkoxylated Hydroxyalky (meth)acrylate, or a Polymeric Methylene Diphenyl Diisocyanate-Hydroxyalkyl (meth)acrylate reacted with a polymeric methylene diphenyl diisocyanate with d + 1 moles of a polyalkoxylated hydroxyalkyl (meth)acrylate or a hydroxyalkyl (meth)acrylate. The procedure is the same as disclosed in Example 3 above. The resulting polymer has a general formula as follows: 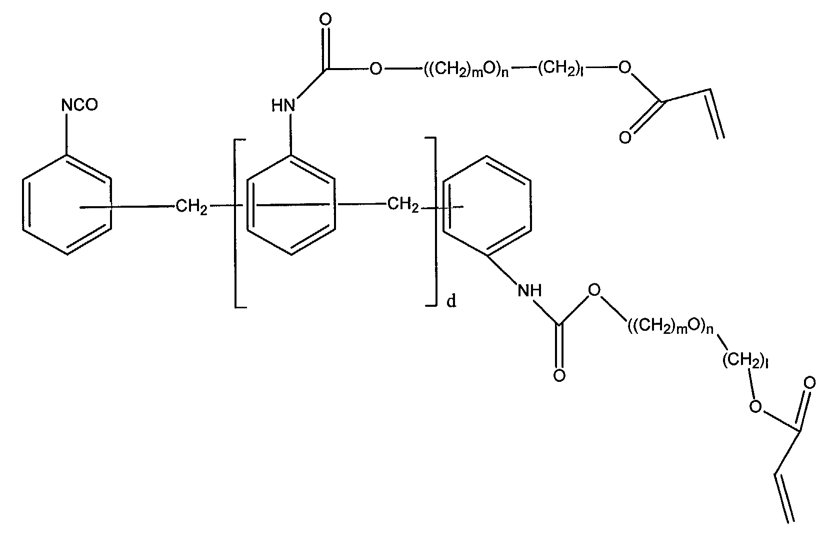 where n is an integer of from 0 to greater than 1000, preferably from 1 to 200, 1 and m are integers of from 1 to 10, and d is an integer of from 0 to greater than 1000, preferably from 1 to 100. The polymeric methylene diphenyl diisocyante-polyalkoxylated hydroxyalkyl, or the polymeric methylene diphenyl diisocyante-hydroxyalkyl (meth)acrylate is reacted with a polymer main chain containing one or more of carboxyl, hydroxyl, or aminyl group to form a functionalized polymer of the present invention.

### Example 7

### Synthesis of Isophorone Diisocyanate-Polyalkoxylated Hydroxyalkyl (meth)acrylate, or Isophorone Diisocyanate-Hydroxyalkyl (meth)acrylate

About one mole of isophorone diisocyanate is reacted with about one mole of a polyalkoxylated hydroxyalkyl (meth)acrylate or about one mole of a hydroxyalkyl (meth)acrylate according to the process described in Example 3 above. The resulting compounds have the following general formula: 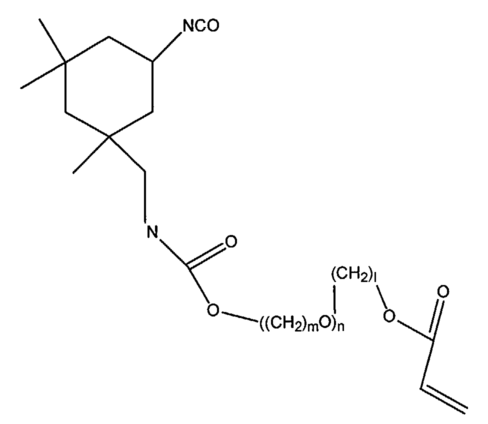 where n is an integer of from 0 to greater than 1000, preferably from 1 to 200, and 1 and m are integers of from 1 to 10. A isophorone diisocyanate-polyalkoxy (meth)acrylate or a isophorone diisocyante-hydroxyalkyl (meth)acrylate may be reacted with a polymer with at least one or more groups of carboxyl, hydroxyl, or aminyl to form a functionalized polymer.

### Example 8

### Isophorone Diisocyante-Bisphenol Diacrylate-Diisocyanate Trimer

About one mole of isophorone diisocyanate is reacted with about one mole of bisphenol diacrylate which is reacted with about one mole of 1,6-hexamethylene diisocyanate trimer. About one mole of the resulting compound is then reacted with about two moles of a polyalkoxylated hydroxyalkyl (meth)acrylate, or two moles of a hydroxyalkyl (meth)acrylate. The reaction conditions and procedure are the same as in Example 3 above. 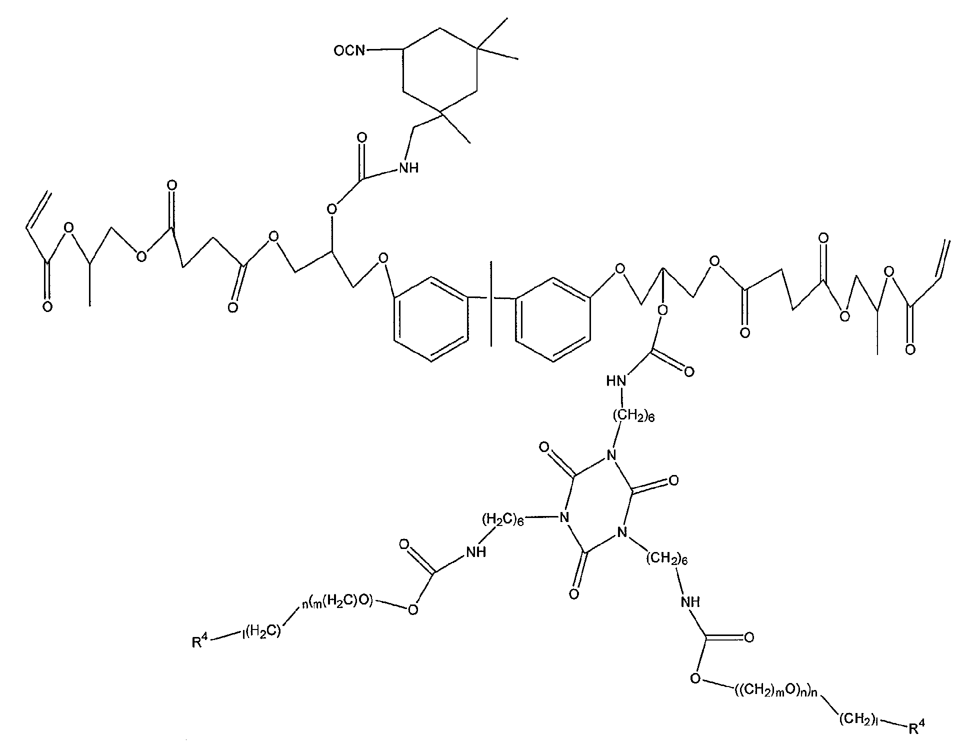 where n is an integer of from 0 to greater than 1000, preferably from 1 to 200, 1 and m are integers of from 1 to 10, R⁵ is hydrogen or methyl and R⁴ is acrylate or methacrylate. The foregoing compounds may be reacted with a polymer chain having at least one of carboxyl, hydroxyl, or aminyl according to a method of the present invention to make a functionalized polymer.

### Example 9

Sixteen dry film photoresist compositions were prepared containing a binder polymer with varying amounts of diisocyante derived functional groups. The functional groups were derived from a 1,6-hexamethylene diisocyanate-polypropoxylated hydroxypropyl methacrylate (5 propoxylations) trimer. The binder polymer main chain or backbone was composed of a styrene/acrylic acid copolymer prepared by free radical polymerization. One mole of free isocyanate of the trimer functional groups were attached with one mole of hydroxyl groups of the copolymer main chain according to the method described in Example 1 above. Four of the dry film photoresist compositions contained about 55% by weight of styrene/acrylic acid copolymer as binder with 0% by weight of the trimer functionalized polymer binder, four contained about 15% by weight, four contained about 25% by weight and four compositions contained about 35% by weight of the functionalized polymer binder.

In addition to the polymer binder component, conventional amounts of the oligomers such as ethoxylated bisphenol A dimethacrylate, 2-acryloloxyethyl-2-hydroxyethyl-O-phthalate and propoxylated trimethylol propane triacrylate were added to the photoresist compositions to assist in cross-linking. The total amount of oligomers composed about 15% by weight of the photoresists.

Additives that were also added to the photoresist compositions included bis-chloroimidazole (photoinitiator), leuco-crystal violet (color former/photoinitiator), solvent blue 5 (dye), ethyl ketone (photoinitiator), dimethylaminoethylmethacrylate (stabilizer) and 4,4'-thiobis(6-tert-butyl-m-cresol) (stabilizer) in conventional amounts. The additives composed the balance of the photoresist.

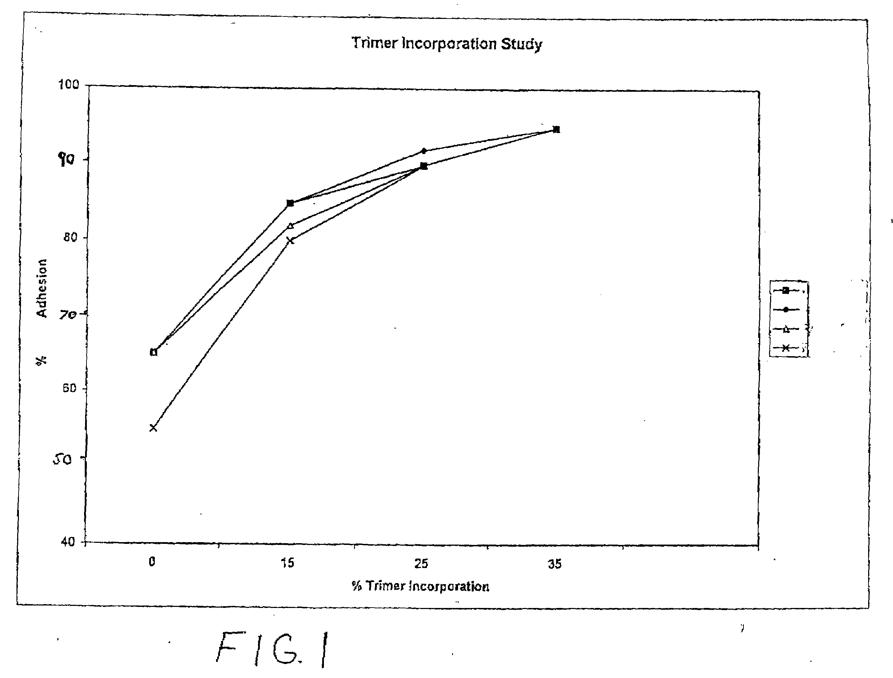

A sample of each of the sixteen dry film photoresist compositions was laminated to individual FR4/glass-epoxy coupons. The dry film photoresist compositions were developed with about a 1% by weight aqueous solution of sodium carbonate in a standard developing chamber, and then exposed to UV light to harden the dry film. Workers then applied tape to each of the sixteen samples to determine the adhesive properties of the photoresists. The percent of photoresist that remained after the tape was removed was plotted against the percent trimer containing polymer binder for all sixteen samples. Figure 1 shows the results. Photoresist samples designated by squares and triangles were developed at the middle of the development chamber, while the photoresists designated by the diamonds and the crosses were developed about ¼ of the way in the development chamber.

Photoresist compositions having 0% trimer containing polymer binder had a coupon adhesion of from about 55% to about 65% by weight of the photoresist. Photoresist compositions containing about 15% trimer containing polymer binder had a coupon adhesion of from about 75% to about 85% by weight. A photoresist containing about 25% trimer containing polymer binder resulted in photoresist coupon adhesion of from above about 85% to over 90% by weight. A photoresist containing about 35% of trimer containing polymer binder resulted in photoresist coupon adhesion of about 95% by weight. Thus, incorporation of a functionalized polymer within the scope of the present invention showed improved adhesion properties.

### Example 10

In addition to testing the adhesive properties of compositions containing functionalized polymers within the scope of the present invention, underplating was also tested. Underplating occurs when metal is plated under the edge of photoresist laminated on a printed wiring board. Such underplating occurs when photoresist is insufficiently stripped from a substrate that is to be plated. The underplated or under cut metal can lead to shorts in the circuitry of the final product. Accordingly, such underplating is highly undesirable.

Sixteen photoresist compositions were prepared as in Example 9 above. A sample of each composition was laminated on a copper clad FR4/glass-epoxy board. A photomask with a desired pattern was placed over the laminated photoresist and the samples were then exposed to UV radiation. After the photomasks were removed, the portions of the photoresist that were not exposed to the UV radiation were washed away or stripped from the copper clad boards leaving exposed copper metal.

Each board was then placed in an aqueous copper metal electroplating bath to be copper plated. The copper plating bath was composed of a bath matrix of about 19 g/L of copper (as copper sulfate), about 225 g/L of sulfuric acid and about 50 ppm of chloride (as sodium chloride). After a suitable layer of copper metal was plated on the stripped areas of the boards, the electroplating process was discontinued and the boards were examined for copper underplating.

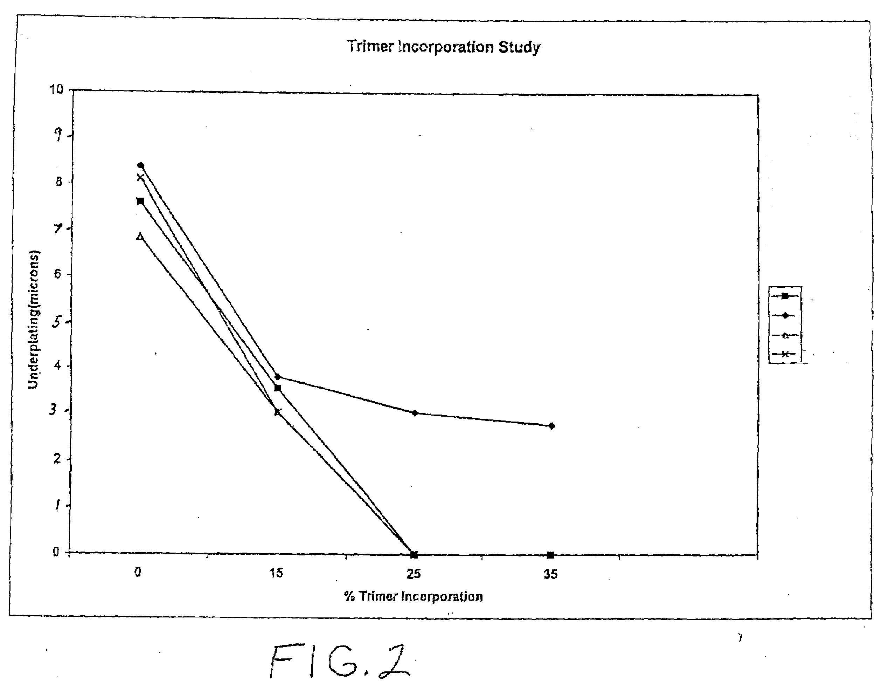

Each sample was examined for copper underplating using an optical microscope which was a standard procedure employed in the art. The results were plotted in a graph of underplating as measured in microns versus percent trimer incorporation in the functionalized polymer as shown in Figure 2. Photoresists that were developed about in the middle of the development chamber are indicated by squares and triangles, while photoresists developed about ¼ of the way in the development chamber are indicated by diamonds and crosses.

Samples that did not contain any trimer in their polymer binder had underplating of from about 7.0 microns to about 8.5 microns in size. When the photoresist composed about 15% by weight of functionalized polymer binder, underplating ranged from about 3 microns to less than about 4 microns. An incorporation of about 25% by weight of the functionalized polymer binder resulted in no sign of underplating except for the photoresist designated by the diamonds in the graph. However, underplating was still reduced to just above 3 microns. Further incorporation of the functionalized polymer binder in amounts of about 35% by weight also resulted in no indication of underplating with the exception of the photoresist designated by the diamond. However, underplating was still reduced to about 3 microns. Thus, the functionalized polymers of the present invention reduced the underplating problem.

### Example 11

Five photoresist compositions were prepared to show the improvement of both adhesion and resolution of photoresists containing functionalized polymers within the scope of the present invention. The polymer main chain for each polymer binder was composed of a styrene/acrylic acid copolymer. The copolymer was prepared by free-radical polymerization of styrene and acrylic acid monomers. Three (test samples 1-3) of the copolymer main chains were functionalized with 1,6-hexamethylene diisocyanate biuret-polypropoxylated hydroxypropyl methacrylate (5 propoxylations) trimers. The copolymers were about 6 mole percent functionalized with the trimer. The copolymer main chains were functionalized with the functional groups by the same process as described in Example 1 above. The fourth photoresist composition (test sample 4) contained a binder polymer that was about 6 mole percent functionalized with 1,6-hexamethylene diisocyanate biuret-ethoxylated caprolactone methacrylate. The fifth photoresist composition (test sample 5) contained an unfunctionalized copolymer main chain and acted as a control. All the photoresist compositions also contained oligomers of ethoxylated bisphenol A dimethacrylate and propoxylated trimethylol propane triacrylate in conventional amounts to act as additional cross-linking agents. Other additives such as photoinitiators, color formers, and stabilizers were added to the formulations in conventional amounts.

Each photoresist composition was laminated to separate copper clad FR4/glass-epoxy coupons. A photomask was placed over each sample with a desired pattern, and then cured by exposing the photoresist to UV radiation. The photomask employed was a standard glass/ chrome art work also known as a G-200 art work. Exposure energy ranged from about 140 to about 180 mJ/cm². A 1% by weight sodium carbonate solution was used to develop the unexposed photoresist leaving exposed copper metal. After developing, each coupon was placed into a copper metal electroplating bath and electroplated. The electroplating bath contained the same matrix as described in Example 10 above.

Each sample was adhesion tested by two different methods. The first method involved the standard tape test where tape was stuck to the surface of the photoresist and then withdrawn to determine how much photoresist remained on the coupon. The test was a visual test and was measured on a scale of 1-5 where 5 had been assigned to a sample that retained the most photoresist on the coupon.

The cross hatch adhesion test involved slitting the surface of the photoresist samples with an edged instrument to create cross hatching on the photoresist surface. Tape was then applied to the surface to determine how much photoresist remained on the coupon after the tape was removed. The results of the adhesion tests are disclosed in the Table below.

After the adhesion tests were done, the resolution of the photoresist features were measured on each of the samples. Resolution was measured using an optical microscope. Such measuring procedures are well known in the art. The resolution measurements are disclosed in the Table below.

**TABLE**

| **Test Sample** | **Tape Adhesion Test (1-5, 5 is best)** | **Cross Hatch Adhesion Test (% by weight remaining on coupon)** | **Resolution (microns)** |
|---|---|---|---|
| 1 | 5 | 95.0 | 18 |
| 2 | 5 | 98.0 | 22.5 |
| 3 | 5 | 90.0 | 25 |
| 4 | 5 | 65.0 | 25 |
| 5 (control) | 5 | 50.0 | 25 |

The tape adhesion test showed that all 5 samples tested provided good results. There were no visible signs that significant amounts of photoresist were removed from the coupons by the tape. However, the results of the cross hatch adhesion test showed that the photoresists that contained the functionalized polymers of the present invention had better adhesion. Samples 1 through 4 had photoresist retention of 95.0%, 98.0%, 90.0% and 65% by weight. The control, sample 5, had only a 50% by weight photoresist retention. Thus the tape in sample 5 removed half of the photoresist on the coupon.

The resolution of the photoresists made with functionalized polymers of the present invention had equal or better resolution than the control. Samples 1 and 2 had resolutions of 18 microns and 22.5 microns, respectively, in contrast to the control that had a resolution of 25 microns.

Accordingly, the photoresists of the present invention showed improved adhesion and resolution over a control photoresist composition. The cross hatch adhesion test is a more reliably accepted test in the art for photoresist adhesion than the tape adhesion test, and the photoresists of the present invention proved superior to the control. Resolution of the photoresists also showed improvement over the control. Resolutions of 18 microns and 22.5 microns enable the formation of smaller features on a printed circuit board, thus enabling further miniaturization of electronic components.

## Claims

1. A functionalized polymer comprising a main chain derived from polymerizable monomers, and at least one functionalized pendent moiety derived from an isocyanate compound joined to the polymer main chain by a linkage of an isocyanate group and a functional group of the main chain, at least one of the functionalized pendent groups comprises a terminal α or β ethylenically or acetylenically unsaturated group.

2. The functionalized polymer of claim 1, wherein the linkage has a general formula:
R-NH-C(O)-P; R-NH-C(O)-NR¹-G-P; or R-NH-C(O)-O(AO)ₓ-C(O)-P
where P is the polymer main chain, R is a functionalized pendent moiety comprising the α or β ethylenically or acetylenically unsaturated group, G is an organic moiety that joins nitrogen to the polymer backbone, R¹ is linear, branched, unsubstituted or substituted alkyl, or unsubstituted or substituted aryl, A is linear or branched (C₁ to C₂₄)alkyl, and x is an integer from 0 to 1,000.

3. The functionalized polymer of claim 1, wherein the polymer main chain is functionalized with the isocyanate compound from about 1 mole percent to about 100 mole percent.

4. A method of preparing a functionalized polymer comprising: reacting hydroxyl, carboxyl or aminyl groups of a polymer main chain with an isocyanate group of an isocyanate compound comprising a terminal α or β functional groups to form a functionalized polymer.

5. The method of claim 4, wherein the isocyanate group is joined to the main chain by a linkage having a general formula:
R-NH-C(O)-P; R-NH-C(O)-NR¹-G-P; or R-NH-C(O)-O(AO)ₓ-C(O)-P
where P is the polymer main chain, R is the functionalized pendent group terminating in an *α, β* ethylenically or acetylenically unsaturated group, G is an organic moiety that joins nitrogen to the polymer backbone, R¹ is a linear, branched or unsubstituted or substituted alkyl or an unsubstituted or substituted aryl, A is a linear or branched (C₁-C₂₄)alkyl, and x is an integer from 0 to 1,000.

6. A photoimageable composition comprising a polymer binder comprising a main chain composed of polymerized monomers and at least one functionalized pendent moiety derived from an isocyanate compound with a terminal α, β ethylenic or acetylenic group, and a photoinitiator.

7. The photoimageable composition of claim 6, wherein the isocyanate compound is joined to the polymer main chain by a linkage having a formula:
R-NH-C(O)-P; R-NH-C(O)-NR¹-G-P; or R-NH-C(O)-O(A)ₓ-C(O)-P
where R is the functionalized pendent group comprising an α, β ethylenically or acetylenically unsaturated moiety, G is an organic moiety that joins nitrogen to the polymer backbone, R¹ is hydrogen, linear, branched, unsubstituted or substituted alkyl, or unsubstituted or substituted aryl, P is the polymer main chain, A is linear or branched (C₁-C₂₄)alkyl, and x is an integer of from 0 to 1000.

8. The photoresist of claim 7, wherein the polymer binder comprises from about 5% by weight to about 95% by weight of the photoresist.

9. The photoresist composition of claim 6, further comprising plasticizers, dyes, stabilizers, flexibilizing agents, fillers, or mixtures thereof.

10. The photoresist of claim 6, wherein the monomers comprise (meth)acrylic acid, (meth)acrylamides, alkenyl (meth)acrylates, aromatic (meth)acrylates, vinyl aromatic monomers, ethylenically or acetylenically unsaturated nitrogen-containing compounds, thio-analogs of ethylenically or acetylenically unsaturated nitrogen-containing compounds, substituted ethylene monomers, cyclic olefins, substituted cyclic olefins, or mixtures thereof.
